# EUROPEAN PATENT SPECIFICATION

(11) **EP 2 993 684 B1**
(45) Date of publication and mention of the grant of the patent: **08.03.2017**
(21) Application number: 15181376.3
(22) Date of filing: 18.08.2015
(51) Int. Cl.: H01J 37/317

(54) **CORRECTION OF SHORT-RANGE DISLOCATIONS IN A MULTI-BEAM WRITER**
KORREKTUR VON VERWERFUNGEN MIT KURZER REICHWEITE IN EINEM MEHRSTRAHLSCHREIBER
CORRECTION DE DISLOCATIONS À COURTE PORTÉE DANS UN GRAVEUR À FAISCEAUX MULTIPLES

(30) Priority: 05.09.2014 EP 14183705
(43) Date of publication of application: 09.03.2016
(73) Proprietor: IMS Nanofabrication AG, 1020 Wien (AT)
(72) Inventor: Platzgummer, Elmar, 1090 Wien (AT); Spengler, Christoph, 6020 Innsbruck (AT); Wagner, Markus, 1130 Wien (AT); Kvasnica, Samuel, 1140 Wien (AT)
(74) Representative: Patentanwaltskanzlei Matschnig & Forsthuber OG

(56) References cited:
- US-A- 4 467 211
- US-A- 5 933 211
- US-B1- 6 552 353

## Description

### Field of the invention and description of prior art

The invention relates to the field of charged-particle multi-beam processing apparatuses for the exposure of a target by means of a structured beam of electrically charged particles, and in particular to a method for computing an exposure pattern for exposing a desired pattern on a target in a charged-particle lithography apparatus. In such an apparatus a particle beam is generated in an illumination system, is directed to and illuminates a pattern definition device comprising an aperture array composed of a plurality of blanking apertures through which said particle beam penetrates and is then imaged by a projection optics system onto a target, for writing said desired pattern by exposing a multitude of pixels within an exposure area on the target.

The applicant has realized charged-particle multi-beam tools of the mentioned type and developed corresponding charged-particle optics, pattern definition (PD) device, and multi-beam writing method, in particular a 50keV electron multi-beam writer to realize leading-edge complex photomasks for 193nm immersion lithography, of masks for EUV lithography and of templates (1x masks) for imprint lithography. The system is called eMET (electron Mask Exposure Tool) or MBMW (multi-beam mask writer) for exposing 6" mask blank substrates. The multi-beam system has been called PML2 (Projection Mask-Less Lithography) for electron beam direct writer (EBDW) applications on Silicon wafer substrates. The multi-beam column and writing method can also be used for multi-beam inspection applications.

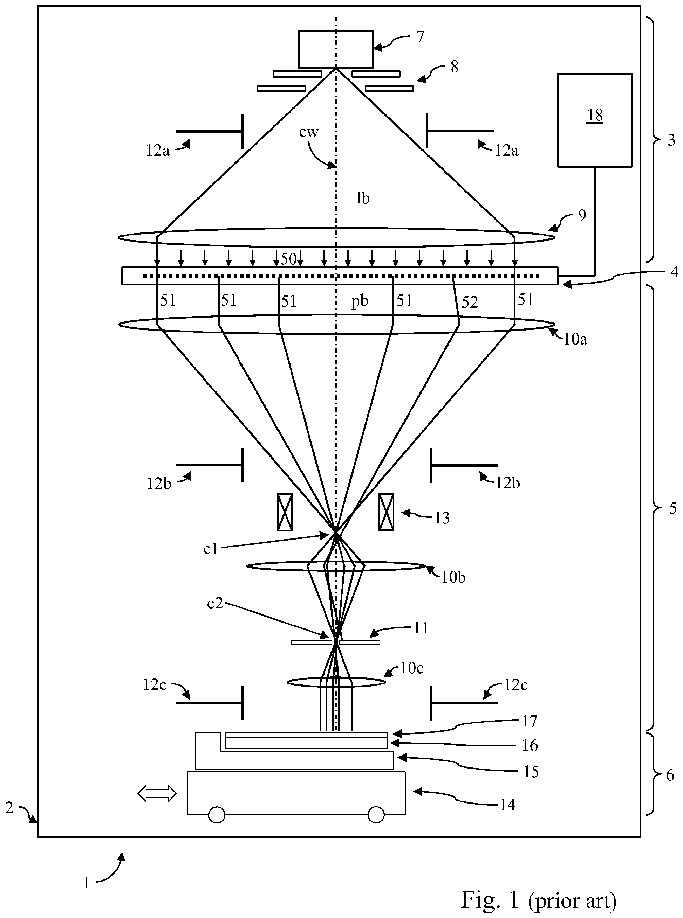

The schematics of the multi-beam writer are shown in Fig. 1. Such a lithographic apparatus is well known in prior art, such as US 6,768,125 , EP 2 187 427 A1 (= US 8,222,621) and EP 2 363 875 A1 (= US 8,378,320). In the following, only those details are given as needed to disclose the invention; for the sake of clarity, the components are not shown to size in Fig. 1. The main components of the lithography apparatus 1 are - corresponding to the direction of the lithography beam lb, pb which in this example runs vertically downward in Fig. 1 - an illumination system 3, a pattern definition (PD) system 4, a projecting system 5, and a target station 6 with the substrate 16. The whole apparatus 1 is contained in a vacuum housing 2 held at high vacuum to ensure an unimpeded propagation of the beam lb, pb along the optical axis cx of the apparatus. The charged-particle optical systems 3, 5 are realized using electrostatic and/or magnetic lenses.

The illumination system 3 comprises, for instance, an electron gun 7, an extraction system 8 as well as a condenser lens system 9. It should, however, be noted that in place of electrons, in general, other electrically charged particles can be used as well. Apart from electrons these can be, for instance, hydrogen ions or heavier ions, charged atom clusters, or charged molecules.

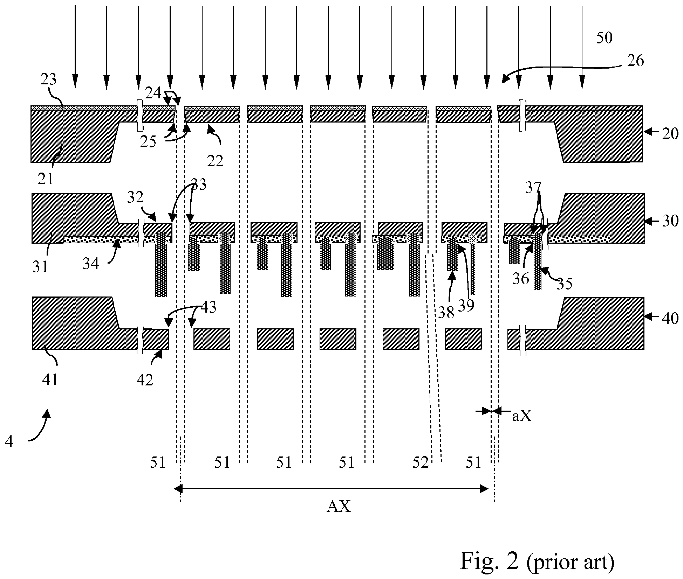

The extraction system 8 accelerates the particles to a defined energy of typically several keV, e.g. 5 keV. By means of a condenser lens system 9, the particles emitted from the source 7 are formed into a wide, substantially telecentric particle beam 50 serving as lithography beam lb. The lithography beam lb then irradiates a PD system 4 which comprises a number of plates with a plurality of openings or apertures 24 (Fig. 2). The PD system 4 is held at a specific position in the path of the lithography beam lb, which thus irradiates the plurality of apertures and is split up into a number of beamlets.

Referring to Fig. 2, some of the apertures 24 of the PD system 4 are "switched on" or "open" so as to be transparent to the incident beam in the sense that they allow the portion of the beam (beamlets 51) that is transmitted through it to reach the target; the other apertures are "switched off" or "closed", i.e. the corresponding beamlets 52 cannot reach the target, and thus effectively these apertures and/or openings are non-transparent (opaque) to the beam. Thus, the lithography beam lb is structured into a patterned beam pb, emerging from the PD system 4. The pattern of switched on apertures - the only portions of the PD system 4 which are transparent to the lithography beam lb - is chosen according to a pattern which is to be exposed on the target 16. It has to be noted that the "switching on/off" of the beamlets usually is realized by some sort of deflection means provided in one of the plates of the PD system 4: "Switched off"-beamlets are deflected off their path (by very small angles) so they cannot reach the target but are merely absorbed somewhere in the lithography apparatus, e.g. by an absorbing plate 11.

The pattern as represented by the patterned beam pb is then projected by means of an electro-magneto-optical projection system 5 onto the substrate 16 where it forms an image of the "switched-on" apertures and/or openings. The projection system 5 implements a demagnification of, for instance, 200:1 with two crossovers c1 and c2. The target or "substrate" 16 is, for instance, a 6" mask blank or a silicon wafer covered with a particle sensitive resist layer 17. The substrate is held by a chuck 15 and positioned by a substrate stage 14 of the target station 6.

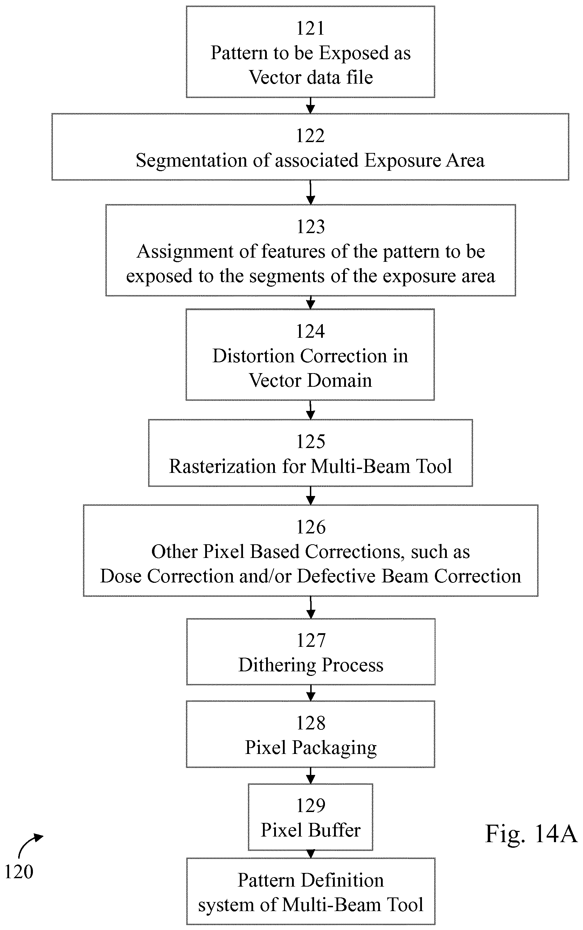

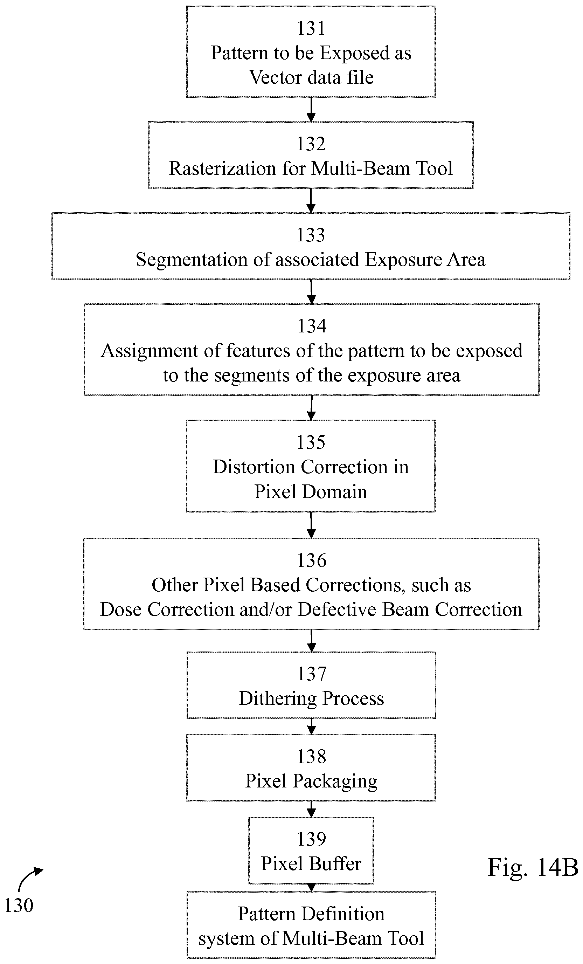

The information regarding the pattern to be exposed is supplied to the PD system 4 by a data path realized by means of an electronic pattern information processing system 18. (Also see discussion of Figs. 14A and 14B below.)

In the embodiment shown in Fig. 1, the projection system 5 is composed of a number of consecutive electro-magneto-optical projector stages 10a, 10b, 10c, consisting of electrostatic and/or magnetic lenses and other deflection means. These lenses and means are shown in symbolic form only, since their application is well known in the prior art. The projection system 5 employs a demagnifying imaging through crossovers c1, c2. The demagnification factor for both stages is chosen such that an overall demagnification of several hundred results, e.g. 200:1. A demagnification of this order is in particular suitable with a lithography setup, in order to alleviate problems of miniaturization in the PD device.

In the whole projection system 5, provisions are made to extensively compensate chromatic and geometric aberrations. As a means to shift the image laterally as a whole, i.e. along a direction perpendicular to the optical axis cx, deflection means 12a, 12b and 12c are provided in the condenser 3 and projection system 5. The deflection means can be realized as, for instance, a multipole electrode system which is positioned near the source extraction system (12a), near the first crossover, as shown in Fig. 1 with the deflection means 12b, and/or after the final lens 10c of the respective projector, as in the case with the stage deflection means 12c in Fig. 1. In this apparatus, a multipole electrode arrangement is used as deflection means both for shifting the image in relation to the stage motion and for correction of the imaging system in conjunction with the charged-particle optics alignment system. These deflection means 10a, 10b, 10c are not to be confused with the deflection array means of the PD system 4 which, in conjunction with the stopping plate 11, are used to switch selected beamlets of the patterned beam pd to "on" or "off" state, since the former only deal with the particle beam as a whole. There is also the possibility to rotate the ensemble of programmable beams using a solenoid 13 providing an axial magnetic field.

As can be seen in the sectional detail of Fig. 2, the PD system 4 preferably comprises three plates stacked in a consecutive configuration: An "Aperture Array Plate" (AAP) 20, a "Deflection Array Plate" (DAP) 30 and a "Field-boundary Array Plate" (FAP) 40. It is worthwhile to note that the term 'plate' refers to an overall shape of the respective device, but does not necessarily indicate that a plate is realized as a single plate component even though the latter is usually the preferred way of implementation; still, in certain embodiments, a 'plate', such as the aperture array plate, may be composed of a number of sub-plates. The plates are preferably arranged parallel to each other, at mutual distances along the Z direction.

The flat upper surface of AAP 20 forms a defined potential interface to the condenser optics/illumination system 11. The AAP may, e.g. be made from a square or rectangular piece of a silicon wafer (approx. 1mm thickness) 21 with a thinned center part 22. The plate may be covered by an electrically conductive protective layer 23 which will be particularly advantageous when using hydrogen or helium ions (line in US 6,858,118). When using electrons or heavy ions (e.g. argon or xenon), the layer 23 may also be of silicon provided by the surface section of 21 and 22, respectively, so that there is no interface between layer 23 and bulk parts 21 / 22, respectively.

The AAP 20 is provided with a plurality of apertures 24 realized as openings traversing the thinned part 22. In the embodiment shown the apertures 24 are realized having a straight profile fabricated into the layer 23 and a "retrograde" profile in the bulk layer of the AAP 20 such that the downward outlets 25 of the openings are wider than in the main part of the apertures 24. Both the straight and retrograde profiles can be fabricated with state-of-the-art structuring techniques such as reactive ion etching. The retrograde profile strongly reduces mirror charging effects of the beam passing through the opening.

The DAP 30 is a plate provided with a plurality of openings 33, whose positions correspond to those of the apertures 24 in the AAP 20, and which are provided with electrodes 35, 38 configured for deflecting the individual sub-beams passing through the openings 33 selectively from their respective paths. The DAP 30 can, for instance, be fabricated by post-processing a CMOS wafer with an ASIC circuitry. The DAP 30 is, for instance, made from a piece of a CMOS wafer having a square or rectangular shape and comprises a thicker part 31 forming a frame holding a center part 32 which has been thinned (but may be suitably thicker as compared to the thickness of 22). The aperture openings 33 in the center part 32 are wider compared to the apertures 24 (by approx. 2 µm at each side for instance). CMOS electronics 34 is used to control the electrodes 35, 38, which are provided by means of MEMS techniques. Adjacent to each opening 33, a "ground" electrode 35 and a deflection electrode 38 are provided. The ground electrodes 35 are electrically interconnected, connected to a common ground potential, and comprise a retrograde part 36 to prevent charging and an isolation section 37 in order to prevent unwanted shortcuts to the CMOS circuitry. The ground electrodes 35 may also be connected to those parts of the CMOS circuitry 34 which are at the same potential as the silicon bulk portions 31 and 32.

The deflection electrodes 38 are configured to be selectively applied an electrostatic potential; when such electrostatic potential is applied to an electrode 38, this will generate an electric field causing a deflection upon the corresponding sub-beam, deflecting it off its nominal path. The electrodes 38 as well may have a retrograde section 39 in order to avoid charging. Each of the electrodes 38 is connected at its lower part to a respective contact site within the CMOS circuitry 34.

The height of the ground electrodes 35 is higher than the height of the deflection electrodes 38 in order to suppress cross-talk effects between the beams.

The arrangement of a PD system 12 with a DAP 30 having electrodes oriented downstream as shown in Fig. 2 is only one of several possibilities. Further DAP configurations, e.g. with embedded ground and deflection electrodes, can easily be devised by the skilled person (see other patents in the name of the applicant, such as US 8,198,601 B2).

The third plate 40 serving as FAP has a flat surface facing to the first lens part of the down-stream demagnifying charged-particle projection optics and thus provides a defined potential interface to the first lens 16a of the projection optics. The thicker part 41 of FAP 40 is a square or rectangular frame made from a part of a silicon wafer, with a thinned center section 42. The FAP 40 is provided with a plurality of openings 43 which correspond to the openings 24, 33 of the AAP 20 and DAP 30 but are wider as compared to the latter.

The PD system 4, and in particular the first plate thereof, the AAP 20, is illuminated by a broad charged particle beam 50 (herein, "broad" beam means that the beam is sufficiently wide to cover the entire area of the aperture array formed in the AAP), which is thus divided into many thousands of micrometer-sized beams 51 when transmitted through the apertures 24. The beamlets 51 and 52 will traverse the DAP and FAP unhindered.

As already mentioned, whenever a deflection electrode 38 is powered through the CMOS electronics, an electric field will be generated between the deflection electrode and the corresponding ground electrode, leading to a small but sufficient deflection of the respective beam 52 passing through (Fig. 2). The deflected beam can traverse the DAP and FAP unhindered as the openings 33 and 43, respectively, are made sufficiently wide. However, the deflected beam 52 is filtered out at the stopping plate 15 of the sub-column (Fig. 1). Thus, only those beams which are unaffected by the DAP will reach the substrate.

The reduction factor of the demagnifying charged-particle optics 16 is chosen suitably in view of the dimensions of the beams and their mutual distance in the PD device 4 and the desired dimensions of the structures at the target. This will allow for micrometer-sized beams at the PD system whereas nanometer-sized beams are projected onto the substrate.

The ensemble of (unaffected) beams 51 as formed by AAP is projected to the substrate with a predefined reduction factor R of the projection charged-particle optics. Thus, at the substrate a "beam array field" (BAF) is projected having widths BX = AX/R and BY = AY/R, respectively, where AX and AY denote the sizes of the aperture array field along the X and Y directions, respectively. The beam size of an individual beam at the substrate is given by bX = aX/R and bY = aY/R, respectively, where aX and aY denote the sizes of the beam 51 as measured along the X and Y directions, respectively, at the level of the DAP 30.

It is worthwhile to note that the individual beams 51, 52 depicted in Fig. 2 are representative of a much larger number of sub-beams, typically many thousands, arranged in a two-dimensional X-Y array. The applicant has, for instance, realized multi-beam charged-particle optics with a reduction factor of R = 200 for ion as well as electron multi-beam columns with many thousands (e.g., 262,144) programmable beams. The applicant has realized such columns with a beam array field of approx. 82µm × 82µm at the substrate. These examples are stated for illustrative purpose, but are not to be construed as limiting examples.

As a typical implementation of an MBMW, the applicant has realized a 50keV electron MBMW providing 512 × 512 (262,144) programmable beamlets of 20nm beam size within a 81.92µm × 81.92µm beam array field at the substrate. For the realized writer system the substrate is a 6" mask blank (area: 6" × 6" = 152.4mm × 152.4mm, thickness: 1"/4 = 6.35mm) covered with an electron beam sensitive resist. Furthermore, in the realized system of the applicant multi-beam writing is possible on resist covered 150mm Si wafers.

The current density of the realized MBMW system of the applicant is ≤ 1 A/cm² when using 20nm beam size. Thus, when all programmable 262,144 beamlets are "on" the current is ≤ 1.05µA.

The MBMW column as realized by the applicant has a 1sigma blur of approx. 5nm, as verified experimentally and published in "eMET POC: Realization of a proof-of-concept 50 keV electron multibeam Mask Exposure Tool", by Elmar Platzgummer et al., in Proc. of SPIE Vol. 8166, 816622-1 (2011).

There is the possibility to change the beam size from 20nm to e.g. 10nm. For a column with 200:1 reduction this is straightforward by using an aperture array plate (AAP) with 2µm x 2µm opening size of the apertures instead of 4µm x 4µm opening size. As outlined in US 8,546,767 of the applicant, there is also a possibility of an in-situ change of the beam size.

When using 10nm beam size and providing a current density at the substrate of no higher than 4 A/cm² the current of 262,144 programmable beamlets is again 1.05µA at maximum. Thus, also in this case there is virtually no change of the 1 sigma column blur with current through the column.

The first generation MBMW production tools are targeted to use 20nm and 10nm beams providing up to approx. 1 µA current for all 262,144 programmable beams "on". For following generations of MBMW production tools there is the plan to use even smaller beam size of e.g. 8nm and concurrently to provide e.g. 640 × 640 = 409,600 beamlets within the 81.92µm × 81.92 µm beam array field at the substrate. Keeping the maximum current density at 4 A/cm² will ensure that the maximum current (with all beamlets "on") is 1.05µA. For instance, using a 5nm beam size there allows providing e.g. 1024 x 1024 = 1,048,576 programmable beams within the 81.92µm × 81.92 beam array field at the substrate. again, at a maximum current density of 4 A/cm² the maximum current (with all beamlets "on") is 1.05µA.

The multi-beam writing method proposed by the applicant also includes a method using the same spot size, e.g. 20nm, with an overlap between the spots, with a selected amount of overlap. In the "Double Grid" multi-beam exposure, the overlap between the spots is half of the beam size in X as well as in Y direction. In the "Quad Grid" multi-beam exposure, the overlap between the spots is a quarter of the beam size in X as well as in Y direction. The spot size at the substrate is aX/R where aX is the opening width of the apertures in the aperture array plate (Fig. 2) and R is the reduction factor of the charged-particle projection optics. Each spot is exposed with discrete dose levels. For instance, when using 4 bits for programming the dose levels, the dose level of each spot can be selected to be 0, 1, 2, ... 14, or 15 units.

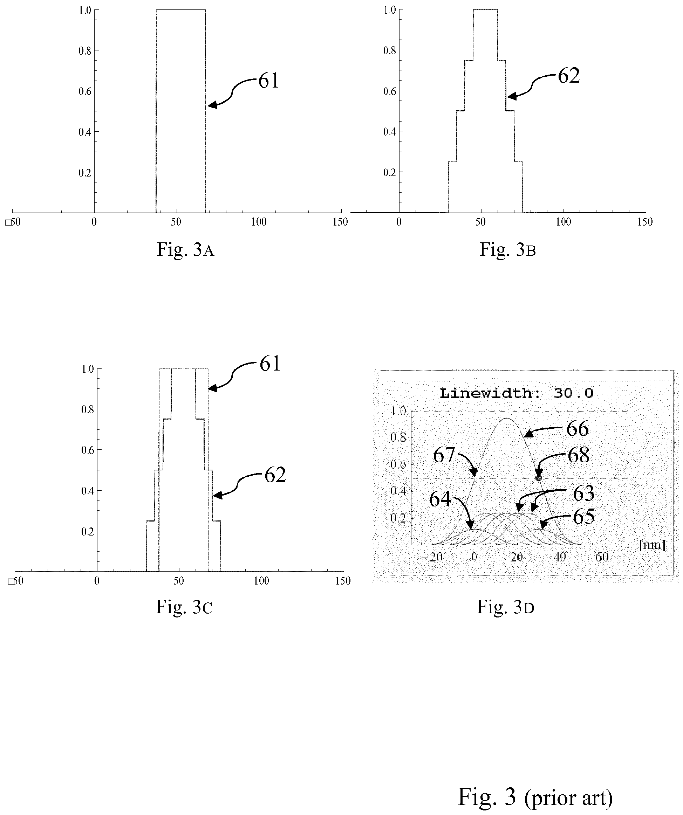

In Fig. 3A, an illustration for the case of a zero blur, the ideal intensity profile 61 is shown for a line with 30nm width. When using "Quad Grid" multi-beam exposure, the overlap is a quarter of the beam size. Thus, for the case of using 20nm beam size the physical grid size is 5nm. A discrete dose level can be assigned to each physical grid area, which is 5nm x 5nm for the example shown, and in Fig. 3B the discrete dose levels 62 applied for generating the 30nm line are indicated. Fig. 3C shows the superposition of the zero blur intensity profile 61 (Fig. 3A) and the dose level histogram 62 (Fig. 3B). In the general case the dose level histogram will not be symmetrical in order to position the left and right edge at pre-defined positions. In Fig. 3D a simulation is shown for a line of 30.0nm width with the left edge to be positioned at 0.0nm and the right edge at 30.0nm. For the simulation, exposure of 20nm beam spots with a 1sigma blur of 5.1nm (12.0nm FWHM blur) was assumed. The intensity profile 66 is formed by overlapping exposure spots 63, 64, and 65. The dose level of the leftmost exposure spot 64 is adjusted such that the 30nm line starts at position 67, i.e. the desired 0.0nm position. The dose level of the rightmost exposure spot 65 is adjusted such that exposed line ends at 68 with 30.0nm width. As shown in Fig. 3D, the overlap of the 20nm exposure spots 63, 64, 65 is a quarter of the beam size, i.e. 5nm ("Quad Grid").

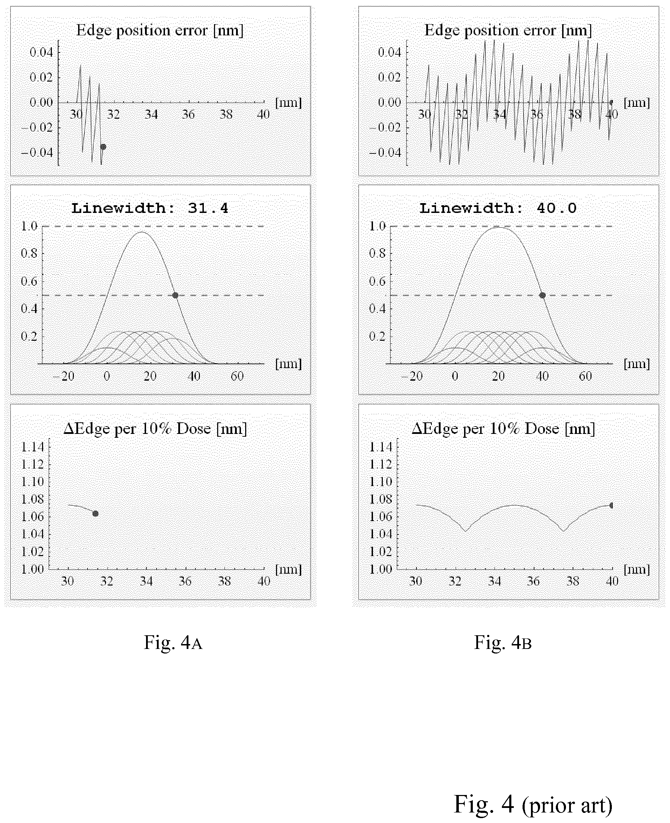

Using the multi-beam exposure tool with 20nm beam size and Quad Grid exposure (5nm physical grid size), the line width can be changed in steps of 0.1nm. As examples, Fig. 4A shows the intensity profile for 31.4nm line width and Fig. 4B for 40.0nm line width. Because of the integer dose levels there are slight deviations from the 0.1nm address grid. These deviations are indicated as "edge position error" in the upper parts of Fig. 4A and Fig. 4B, as functions of the desired line width, in 0.1nm steps between 30.0nm and 40.0nm. As can be seen the deviations are within ±0.05 nm. Furthermore, the changes of edge position with 10% change of dose, as shown in the lower parts of Fig. 4A and Fig. 4B, are approx. 1nm, varying only slightly for different line widths. In other words, since the dose is controlled in a multi-beam writer tool of the applicant to better than 1%, there is only approx. 0.1nm change of edge position with 1% change of dose.

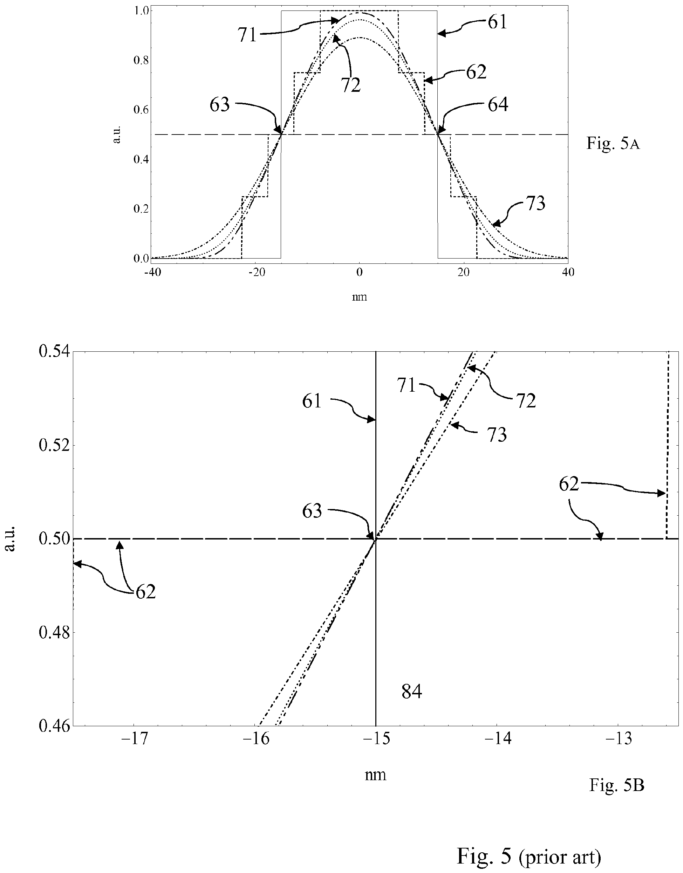

Fig. 5A illustrates one advantage of the multi-beam writer, namely, that the line width is virtually independent of blur variations at the 50% dose threshold. The edge positions 63 and 64 are where the zero blur intensity profile 61 crosses the "0.5" intensity level (Fig. 5A and Fig. 5B). The dose level assignments 62 are for using 20nm beam size with 1sigma blur of 5nm and Quad Grid multi-beam exposure, providing a 5nm physical grid. The intensity profiles 71, 72, and 73 are calculated with 3.5nm, 5.0nm, and 7.5nm 1 sigma blur, respectively.

As outlined above, the multi-beam tool column as realized by the applicant has a very low blur of approx. 5nm 1 sigma. Therefore, the condition that the line width is independent of blur variations holds for a large range of beam size values, including 20nm and 10nm beam size.

When writing a pattern on a substrate such as a 6" mask blank or silicon wafer, there are non-ideal situations which have to be taken into account during the multi-beam writing process in order to realize a mask or wafer with desired features and pattern fidelity. Possible problems to be taken into account are e.g. distortions of the substrate due to processing, distortions of the beam array field which cannot be corrected via optical deflection means, "loading effects" in a subsequent etching process, or charge induced influences. These effects can be simulated and/or measured. Corresponding data may be provided beforehand when preparing the data file for the patterns to be printed with the multi-beam writer ("data based correction"), or these effects may be calculated on basis of a model of the effect ("model based correction"). In most cases it turns out that corrections have to be done for substrate segments which are smaller than the size (area) of the beam array field, in order to meet the high demands of modern and future nanolithography technology.

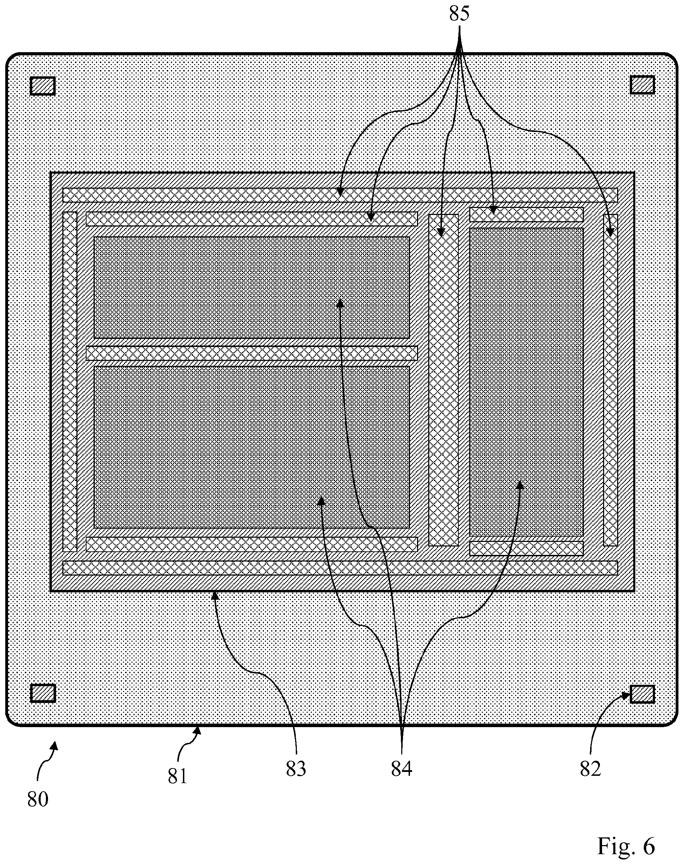

Fig. 6 illustrates one example of local distortions in a target realized as a 6" photomask blank 80 consisting of a 6" x 6" x 1"/4 quarzglass plate 80 covered with an electrically conducting masking layer and an electron beam sensitive resist. The local distortions may be caused by pattern density variations within the mask pattern field 83 of typically 133mm x 104mm. Within this mask pattern field there may be areas of different density of exposed spots, for instance high density 84 and low density 85 pattern areas. In addition, usually there are subfields 82 with patterns for alignment purposes. Of course the invention is not restricted to this type of target but is applicable to a wide range of targets and substrate.

### Summary of the invention

The invention is described in the independent claims 1 and 15. Advantageous developments and further aspects are described in the dependent claims. In detail, the method according to the invention is intended to take into account a spatially dependent distortion of the target within the exposure area, with respect to dislocations transversal to the direction of the particle beam, and it comprises the steps of
(i) subdividing the exposure area into a plurality of non-overlapping sub-regions,
(ii) determining a subregion dislocation for each of said subregions, said subregion dislocation comprising a set of parameters describing (or, in other words, compensating) the distortion of the target at the location of the respective subregion,
(iii) providing the desired pattern as a graphical representation on the exposure area on the target, said graphical representation being composed of a plurality of graphical elements, each graphical element located at a respective position in the exposure area,
(iv) modifying the graphical representation in accordance with the plurality of subregion displacements, by dislocating each graphical element according to a subregion dislocation of the subregion which includes the respective position of the graphical element, obtaining a plurality of graphical elements thus dislocated, which compose a corrected graphical representation,
(v) calculating, from the corrected graphical representation, an exposure pattern defined on the multitude of pixels, said exposure pattern being suitable to create a nominal dose distribution on the target realizing contour lines representing the desired pattern.

In relation to the distortions discussed above, the present invention aims at correcting distortion errors primarily of short-range; that is, for the case when the dislocations induced by the distortion are not constant over the substrate area, and variations of the displacements can be neglected only within (small) regions of the substrate, i.e., subregions of the exposure area, which are preferably of a comparably small area. In particular, the area of a subregion or segment may be comparable or smaller than e.g. the area of the beam array field. The invention suggests that such distortions are taken into account in the data path of the multi-beam writer tool. More specifically, the area to be exposed is divided into a number of non-overlapping subregions, i.e., discrete segments, whose size is customizable and stands in relation to the demanded precision. For instance, in a typical realization of the invention, said area is divided into n x m segments where the area of a segment is smaller than the beam array field, e.g. into rectangular segments of 10.25µm x 10.25µm size when using a 82µm x 82µm beam array field. As will be discussed further below in more detail, the distortion on each segment can be predetermined up to a certain precision using state-of-the-art methods; and this allows compensation of the distortions by modifying the pattern to be exposed accordingly, for instance, by altering the shape and placement of regions of said pattern in accordance to their nominal position in relation to the segmentation of the exposure area/substrate. These modifications take place in the data path before the respective part of the pattern is projected onto the substrate. According to preferred implementations of the invention, these corrections may include scaling in both spatial directions X and Y, rotations, angle corrections and X/Y-displacement/shift corrections. Typically, the distortion correction for each segment is small in comparison to the FWHM (full width half maximum) blur of the multi-beam writer column (it is noted that the FWHM blur is equal to 2.355 times the 1sigma blur).

### Brief description of the drawings

In the following, the present invention is illustrated by several embodiments described below in more detail with reference to the attached drawings. It is emphasized that the embodiments shown here are of illustrative character and are not to be construed as limit the scope of the invention. The drawings schematically show:
- Fig. 1: a charged-particle multi-beam system of state of the art in a longitudinal sectional view;
- Fig. 2: a pattern definition system of state of the art in a longitudial section;
- Figs. 3A-3D: illustrate intensity profiles of the multi-beam mask writer tool, namely, Fig. 3A shows a zero blur intensity profile for a line with 30nm width, Fig. 3B indicates dose levels of overlapping exposure spots, Fig. 3C is a superposition of the previous two figures and Fig. 3D shows a simulated intensity profile 66 for a line of 30nm width;
- Fig. 4: shows multi-beam writer intensity profiles and related data as obtained for simulations of lines with a line width of 31.4nm (Fig. 4A) and 40.0nm (Fig. 4B), respectively;
- Fig. 5A: shows intensity profiles of a 30nm line as exposed with the multi-beam writer tool of the applicant, and
- Fig. 5B: shows a detail of Fig. 5A at the left-hand flank where the intensity profiles cross the 50% intensity level;
- Fig. 6: shows a typical example of the layout of a 6" photomask substrate;
- Fig. 7: shows a segmentation of an exposure area, assuming zero deviation of the X/Y positions of the segments;
- Fig. 8A: shows an example where the segments are assigned distortion corrections, indicated by displacement vectors;
- Fig. 8B: illustrates the distortion corrections as displaced segments;
- Fig. 8C: shows a general assignment of distortion corrections of a single segment; and
- Fig. 8D: shows an example of a general distortion correction including correction types shown in Fig. 8C affecting the exposure area from Fig.7.
- Fig. 9: shows an example of a pattern to be exposed being intersected by the segmentation boundaries of four segments.
- Fig. 10: shows the pattern of Fig.9 after distortion correction according to a first variant of the invention.
- Figs. 11A-C: illustrate the distortion correction according to a second variant of the invention. Fig. 11A illustrates a division of the pattern to be exposed into smaller features according to the second variant. Fig. 11B depicts the pattern after distortion correction. Fig. 11C shows a modified version where the previously divided features of the pattern are reunited.
- Figs. 12A-D: illustrate treatment of critical features crossing a segment boundary. Fig. 12A shows a pattern having a critical feature element. Fig. 12B shows the modification of segment boundaries, so the whole critical element is allocated to one segment. Fig. 14C shows the resulting situation of X/Y shifts. Fig. 14D shows the same situation of Fig.14C in more detail and with exaggerated displacements.
- Figs. 13A+B: illustrate distortion correction according to a third variant. Fig. 13A shows an exemplary division of the pattern into smaller features, and Fig. 13B depicts the pattern after distortion correction.
- Fig. 14A: shows a data path flow wherein the corrected vector data file is generated prior to rasterization.
- Fig. 14B: shows another data path flow wherein the corrected pixel data file is generated after rasterization.
- Fig. 15: illustrates interpolating of correction parameters with the example of the X/Y-displacement vectors. Fig. 15 shows assignments of displacement vectors to nine neighboring different segments. Figs. 15A and 15B show the same assignments separated into the X- and Y- components, respectively, for each vector and segment. Figs. 15C and 15D show contourline plots of interpolated values with respect to the X- and Y-components, respectively, of the relative parameter.

### Detailed description of the invention

Charged-particle multi-beam tools which are suitable for implementing the invention are described above with reference to Figs. 1 to 5B. Further details about multi-beam charged-particle multi-beam tools can be found in US 6,768,125 , EP 2 187 427 A1 and EP 2 363 875 A1 and references cited therein, which are all herewith included by reference as part of the disclosure.

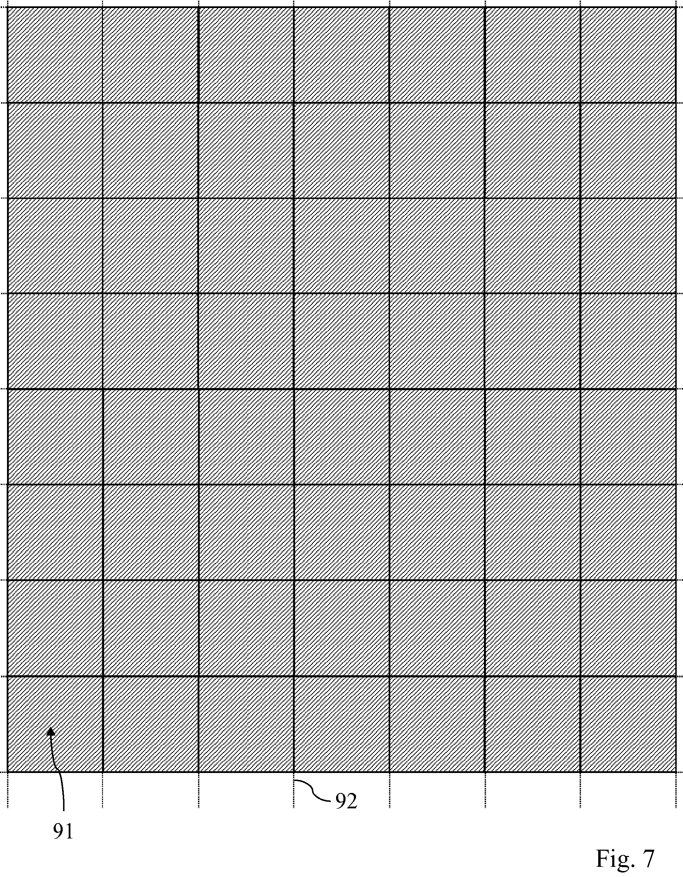

According to the invention, the exposure area is divided into a plurality of discrete subregions, hereinafter mostly referred to as "segments". Fig. 7 shows one example of an exposure area (shown is a part of the area of the substrate pattern field) segmented into segments 91, with respect to an ideal zero deviation of the X/Y positions of segments. The segmentation may, but need not, be a regular grid and/or correspond to a grid aligned along the mathematical grid 92. Preferably, the subregions may be realized as rectangular or quadratic segments 91. It should be noted that the present invention includes all finite-element-coverings of said area. Here, the size (or, area) of the segments (which generally is inversely proportional to their number) is related to the available computational power (speed of the datapath) and demanded precision. Apart from this limitation, the segmentation is chosen freely; ideally, however, appropriately with respect the given distortions. In a typical realization of the invention, the computational power should allow for a maximal segment size which is smaller than the beam array field of the multi-beam writer. For instance, for a mask field of 132mm x 104mm to be exposed with a multi-beam writer possessing a 82µm x 82µm beam array field with 512x512 = 262,144 beamlets, the available computational power of a realistic implementation will allow for a division into segments of approximately 10.25µm x 10.25µm.

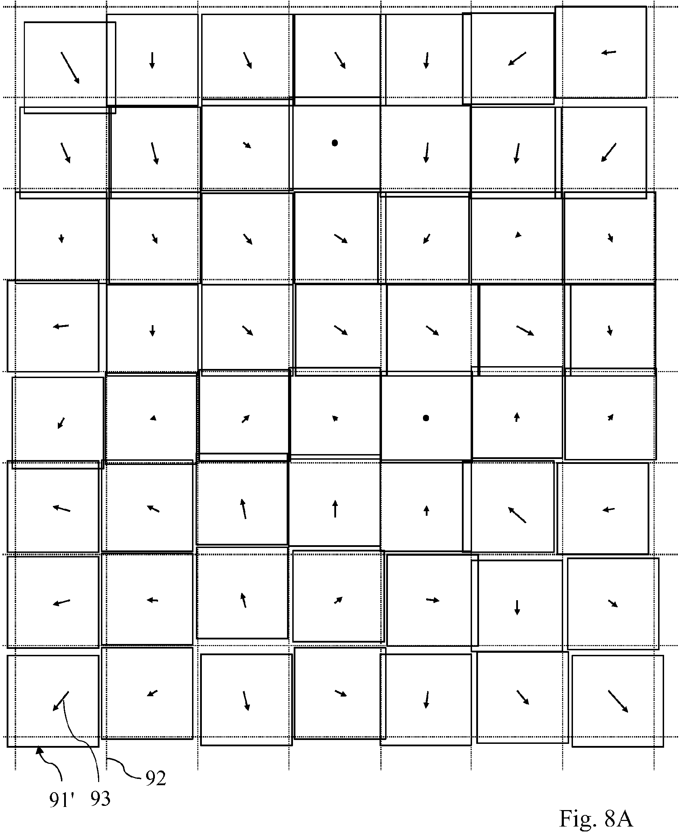

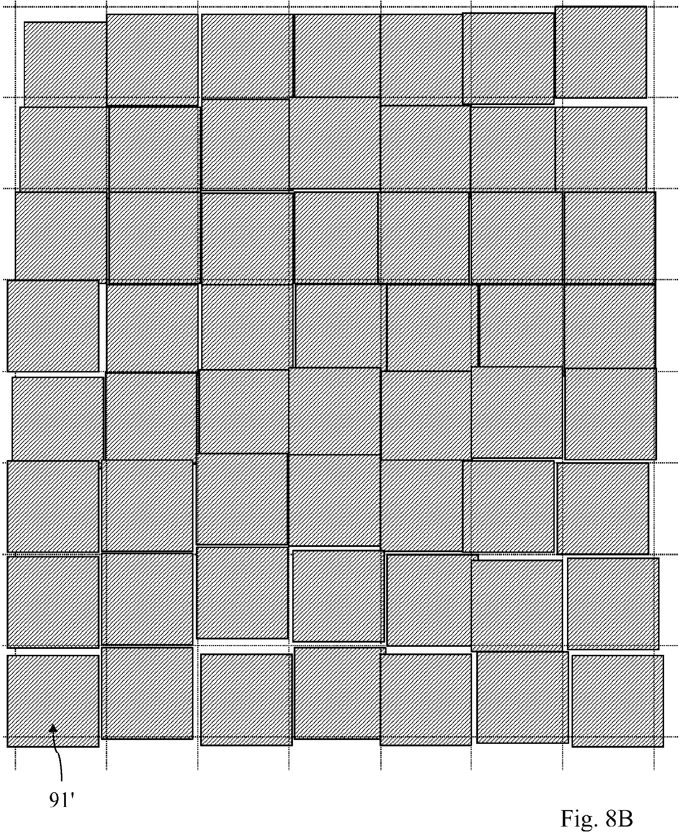

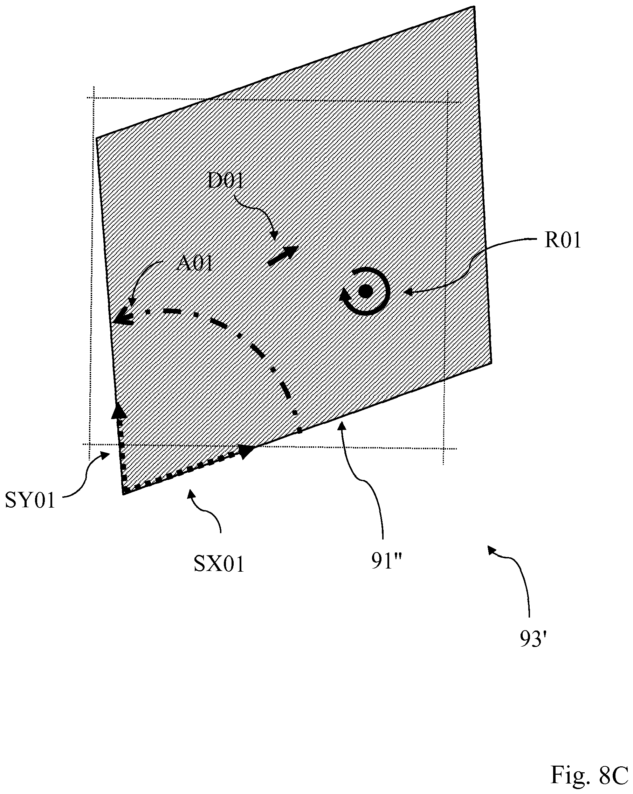

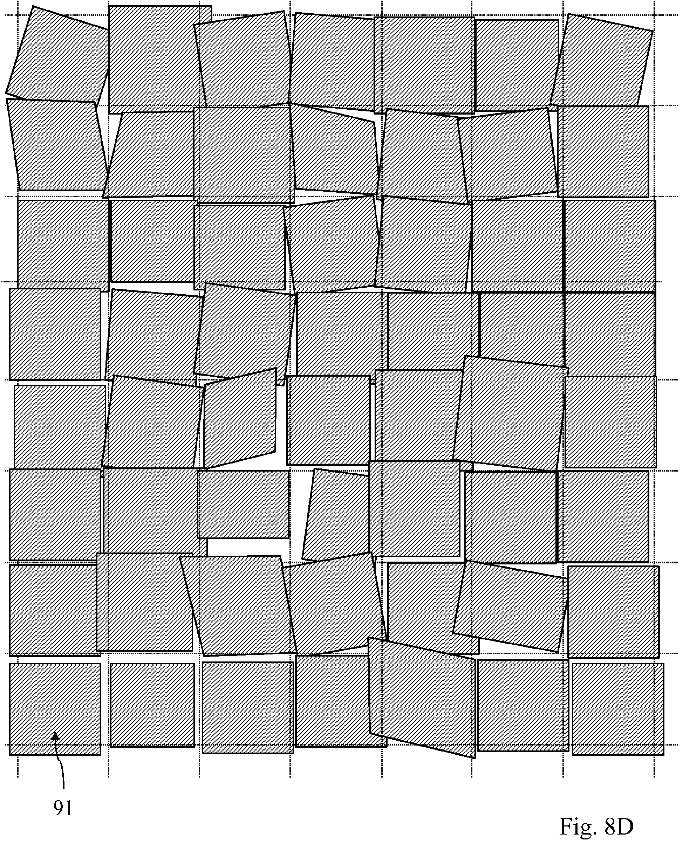

Each of said segments is assigned an individual distortion-correction, which is obtained from model-based and/or measurement-based analyses of the distortions affecting the multi-beam writer tool and specifically the target. Primarily, these corrections concern placement corrections. Fig. 8A shows an example of an assignment of placement correction vectors to the segmentation of Fig. 7, resulting in shift corrections as illustrated in Fig. 8B. In this example, all segments 91' have an X/Y shift with respect to the mathematical grid 92 (with the exception of two segments where the X/Y shift is zero), visualized in Fig. 8A with arrows 93 indicating the direction and symbolizing the amount of the segment area shifts, and in Fig. 8B as hatched segments 91'. Note that these shifts are depicted exaggerated for sake of clarity. In order to allow for higher-order corrections, each of the segments can also be assigned further correction-factors. Within the invention and depicted in Fig. 8C, these corrections may, for instance, include a rotation R01 around a reference point, scaling in X-direction SX01, scaling in Y-direction SY01 and an angle-correction A01, besides the mentioned shift D01 along X and/or Y directions. Each set of parameters describing a correction of a segment is also called a "dislocation" 93' in the context of the present invention. Fig. 8D illustrates the influences on the segments in such a scenario with dislocations according to multiple types of corrections of Fig. 8C. Note that due to angle-correction a rectangular segment may become an arbitrary parallelogram 91". Note further that for the sake of simplicity, all of the following drawings only contain X/Y-placement corrections. However, the invention is not limited to this single correction type.

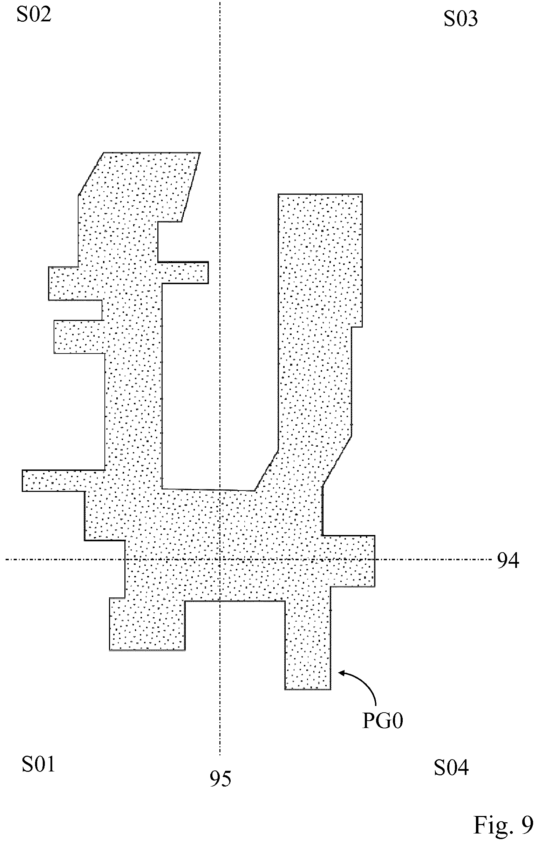

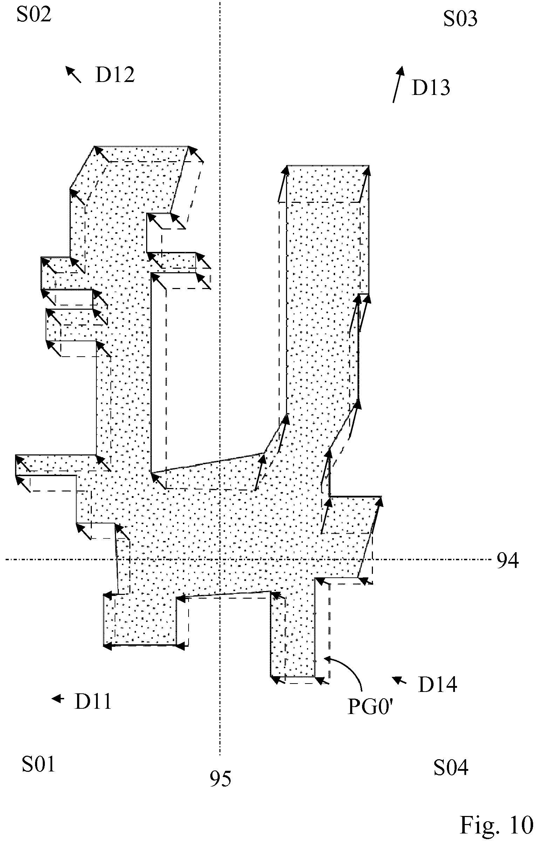

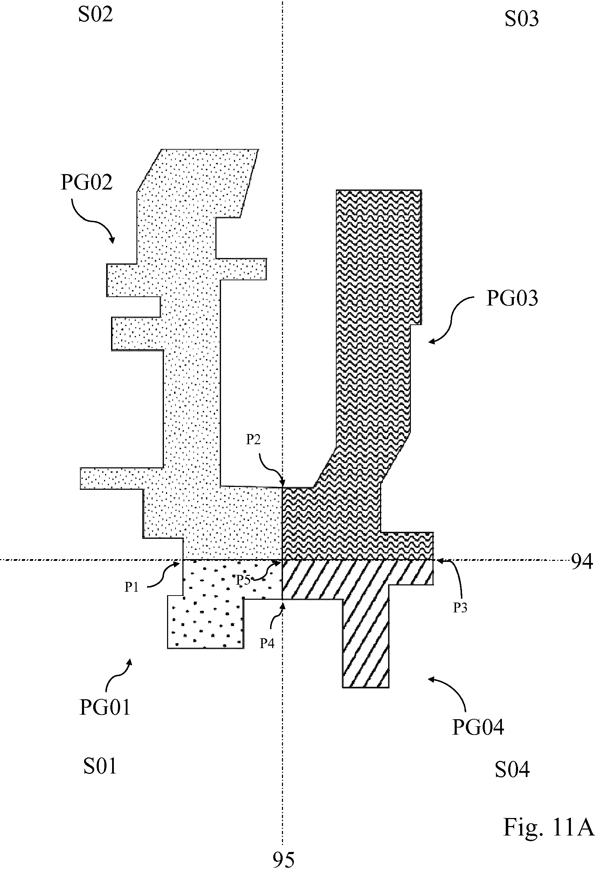

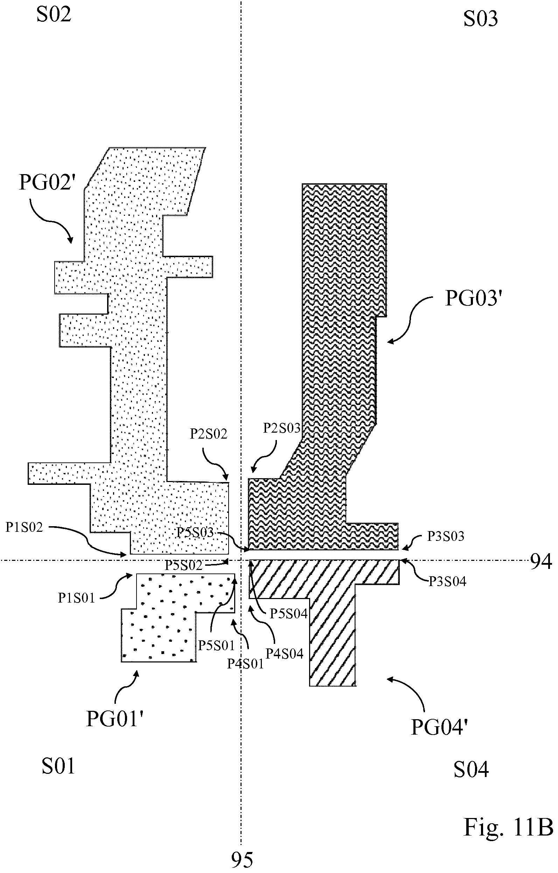

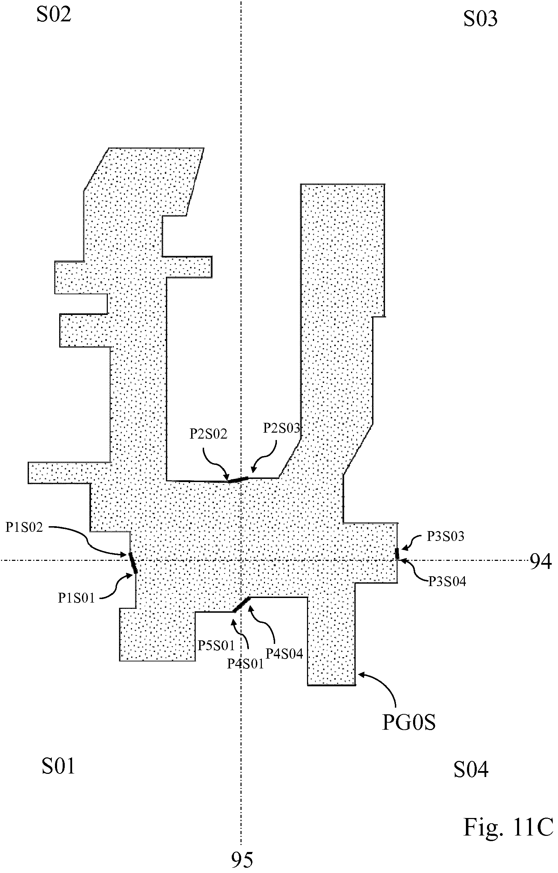

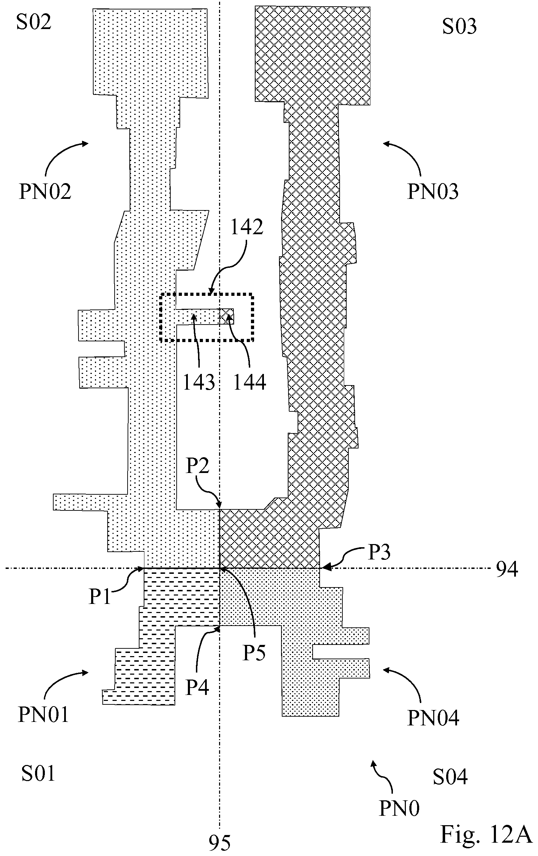

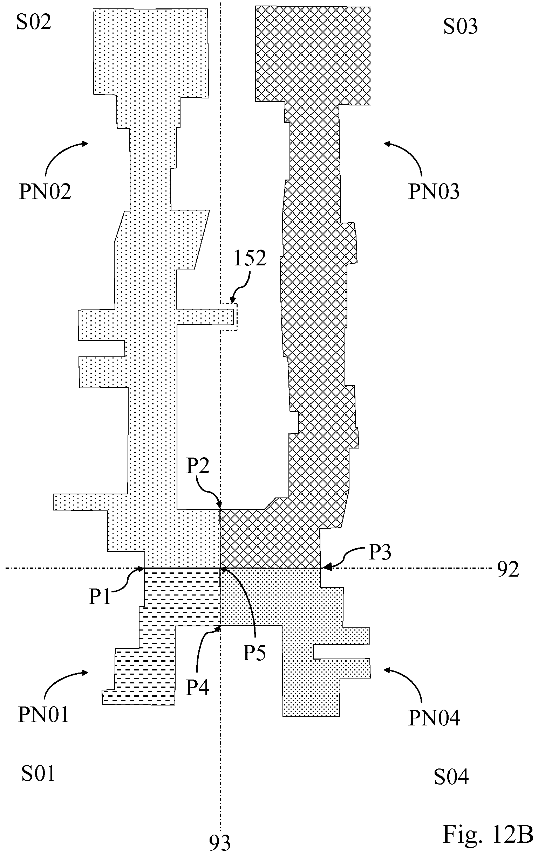

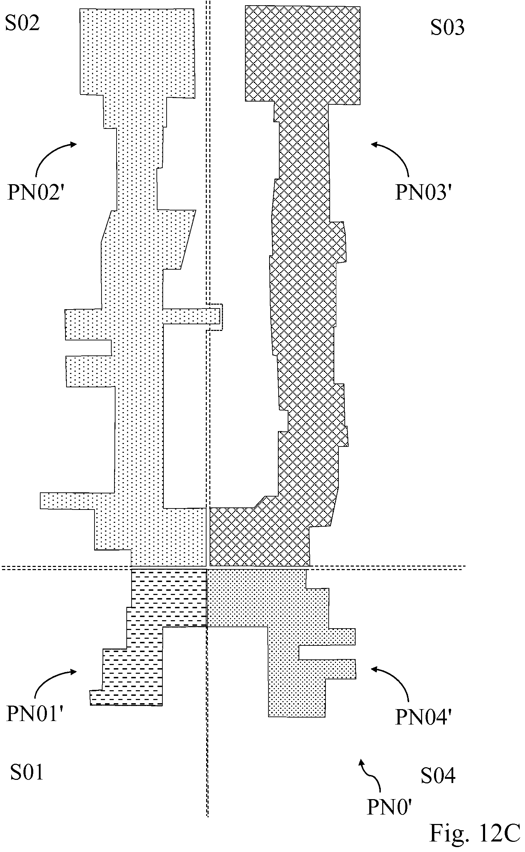

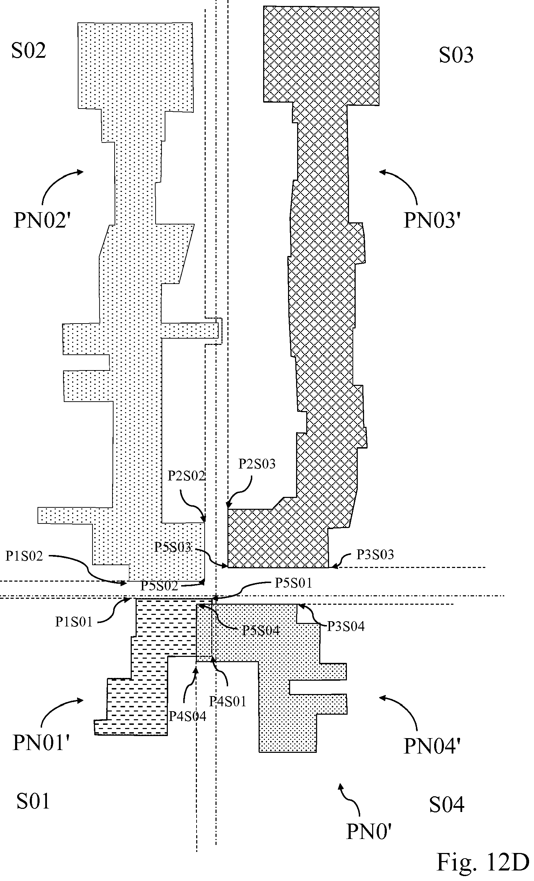

As one important aspect of the invention, the pattern to be exposed is considered for distortion correction. This concerns the way how the corrections assigned to each of the segments, is incorporated in said pattern which is composed of a plurality of graphical elements (e.g., polygons in case of a vector graphics, or pixels in case of a raster graphics). Preferred embodiments of the invention include the following schemes:
a) In a usual application, the pattern to be exposed is given as a polygon, like the polygon PG0 shown in Fig. 9. (In general, a pattern will comprise a plurality of polygons and possibly other structures, such as circular dots, etc.) Here, the lines 94, 95 denote boundaries between the segments S01, S02, S03, S04. Fig. 10 shows how the polygon PG0 will look after distortion correction according to this first variant. The vectors D11, D12, D13, D14 in Fig. 9A are vectors corresponding to displacement/shift corrections assigned to the segments S01, S02, S03, S04. According to one embodiment of the invention, each of the coordinates of the vertices defining the polygon is corrected according to the segment in which it lies. For instance, in Fig. 10 all vertices of the original polygon (depicted in dashed lines) in the upper right segment S03 are collectively shifted by the vector D13. In the more general case of corrections beyond shifts (rotation, X/Y-scaling and angle-correction) all vertex coordinates within one segment are transformed according to the correction that has been assigned to this particular segment.
b) According to a second variant of the invention, the pattern to be exposed is divided into segments at segment borders identical to the boundaries 94, 95 of the segmentation of the exposure area and corrected accordingly. As an illustrating example, Fig. 11A shows how the pattern to be exposed of Fig.9, represented by polygon PG0, is divided by segment lines 94, 95 into four polygons PG01, PG02, PG03, PG04. The points where the polygons PG01, PG02, PG03 and PG04 meet at the segment boundaries 94, 95 are indicated as "border points" P1, P2, P3, P4 and P5 in Fig. 11A. Fig. 11B illustrates the situation after corrections of the segment X/Y positions. It can be seen that the polygons PG01', PG02', PG03' and PG04' have new positions according to the individual distortion correction of each segment. It should be noted that instead of the border points P1, P2, P3, P4, P5 there are now 12 new border points P1S01, P1S02, P2S02, P2S03, P3S03, P3S04, P4S04, P4S01, P5S01, P5S02, P5S03, and P5S04. Furthermore, each of the polygons PG01, PG02, PG03, PG04 may also be rotated, rescaled and angle-corrected (not shown in Fig.11B) according to the correction assignment of the segments.
   In a modified version of variant b), the new border points, in the example P1S01, P1S02, P2S02, P2S03, P3S03, P3S04, P4S04, P4S01, P5S01, P5S02, P5S03, and P5S04, which are a consequence of the segmentation, may also be used to reunify the pattern to be exposed. This optional version of variant b) is visualized in Fig. 11C, where and connections (thick lines Fig. 11C) between the pairs P1S01-P1S02, P2S02-P2S03, P3S03-P3S04, and P4S04-P4S01 enable a reunion of the polygons PG01, PG02, PG03, PG04 (which were separated due to segmentation) into a single polygon PG0S; and the points P5S01, P5S02, P5S03, and P5S04, which are in the interior of the reunified polygon, vanish.
   For a further optional version of variant b), it is important to note that the boundaries of the segments may be adapted in order to avoid the segmentation of critical features. As an example Fig. 12A shows a pattern PN0 with a critical feature 142 of such length that the feature extends beyond the segment boundary. Thus, part 143 of the critical feature would belong to the segment with the main part of pattern PN02, whereas the part 144 of the critical feature 142 would belong to part PN03 in the neighboring segment S03. In order to avoid the segmentation of such a critical feature there is an automatic feature of the datapath algorithm indicating a critical area between segment boundaries. There is then the decision to allocate the critical feature 152 as a whole to one segment only, in this case segment S02, so the critical feature remains part of feature PN02, PN02'. The result of this procedure is given in Fig. 12B where the pattern PN02 is generated including the critical feature. In other words, the segment boundary is altered at the region of the critical feature 152. Fig. 12C shows the situation PN0' after applying a displacement/shift correction. The same is shown in Fig. 12D in more detail, where the coordinate displacements are exaggerated for clarity.
c) According to a third variant, the pattern to be exposed may be divided into a plurality of smaller features (typically but not necessarily polygons) independently from the segmentation of the exposure area. An arbitrary but reasonable reference point of each feature is used to assign each of them to one of the exposure area segments. A reasonable reference point is typically the center-of-mass, or the center of a bounding box enclosing each feature. Subsequently, each feature is distortion corrected according to its segment assignment.
   As for the segmentation of the exposure area, the division of the pattern to be exposed into smaller features can be chosen freely. In a preferred embodiment of the invention there is the option to state a maximal size of the features. Typically, said maximal feature size is chosen small in relation to the segmentation of the exposure area.

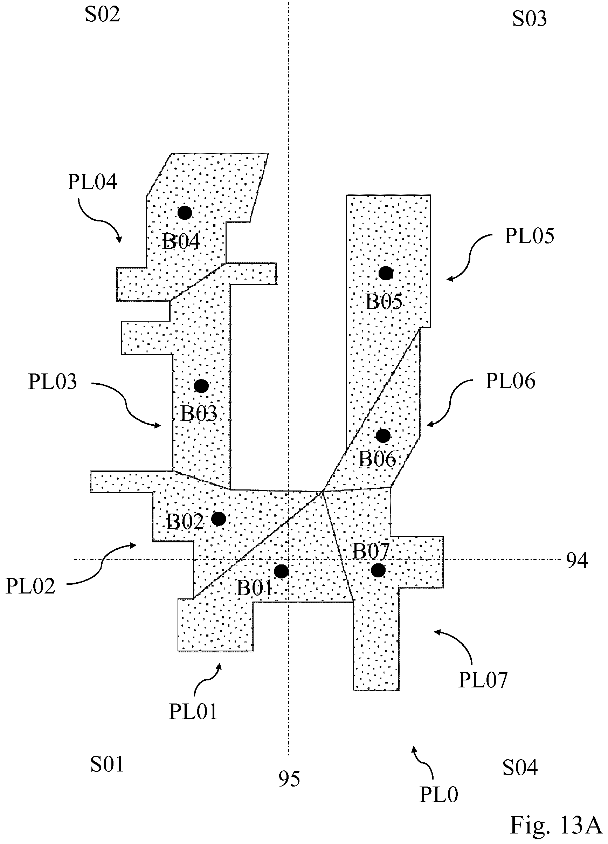

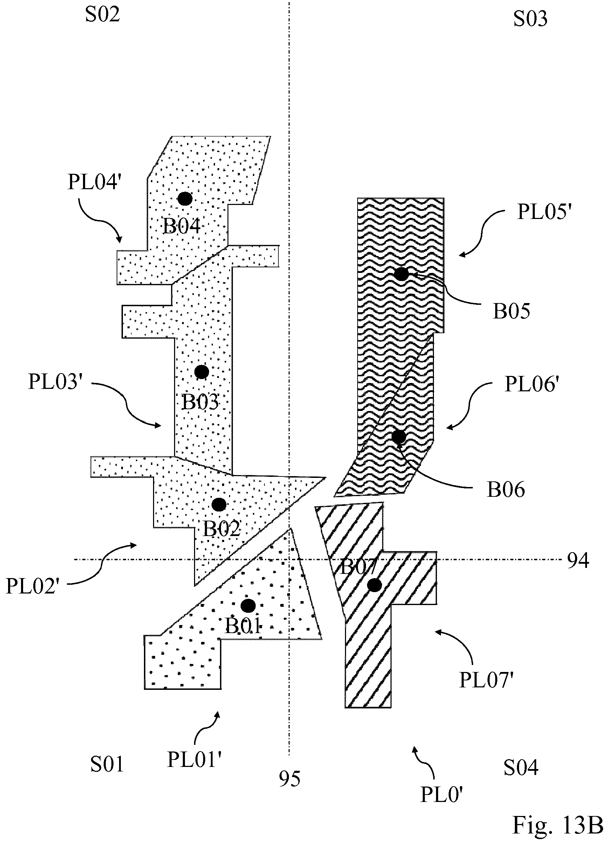

   Fig.13A and Fig.13B illustrate an example of variant c). Fig.13A shows that the exposure pattern of Fig.9 is divided into a plurality of polygons PL0, composed of smaller features (polygon portions) PL01, ..., PL07, irrespective of the boundaries 94, 95 of the segments S01, S02, S03 and S04. Each of the polygon portions PL01...PL07 is assigned a reference point denoted by a B01, ..., B07. In a preferred embodiment of the invention, these reference points are chosen to be the center of masses of the portions PL01...PL07, or the center of a rectangular bounding box minimally surrounding the respective portion (i.e., the center of the rectangular hull along X- and Y-directions). The distortion correction is then applied to each feature according to in which segment its reference point lies. For example, Fig. 13B illustrates that in the resulting structure PL0' comprising new portions PL01'...PL07', the polygon portions PL02', PL03' and PL04' are still connected as their reference points B02, B03 and B04 lie in the same segment S02 and, consequently, are shifted in the same way; whereas other portions are shifted with respect to to each others: for instance, portion PL01' is separated from portion PL02' after distortion correction, since reference point B01 lies in segment S01 whose assigned X/Y-placement-correction differs from the X/Y-placement-correction of segment S02.

Variants a) and c) also allow for applying 2D multivariate interpolation of the distortion correction factors, such as factors D01, R01, SX01, SY01, A01 illustrated in Fig. 8C, with respect to the center of the segments covering the exposure area. In particular, according to this embodiment of the invention, in variant a) each of the coordinates of the vertices defining the polygon is corrected according to the 2-dimensionally interpolated value (for example, via bilinear interpolation, bicubic interpolation, or spline interpolation). In variant c), every feature is distortion corrected according to the interpolated value at its reference point.

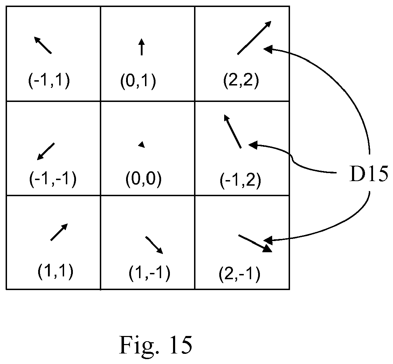

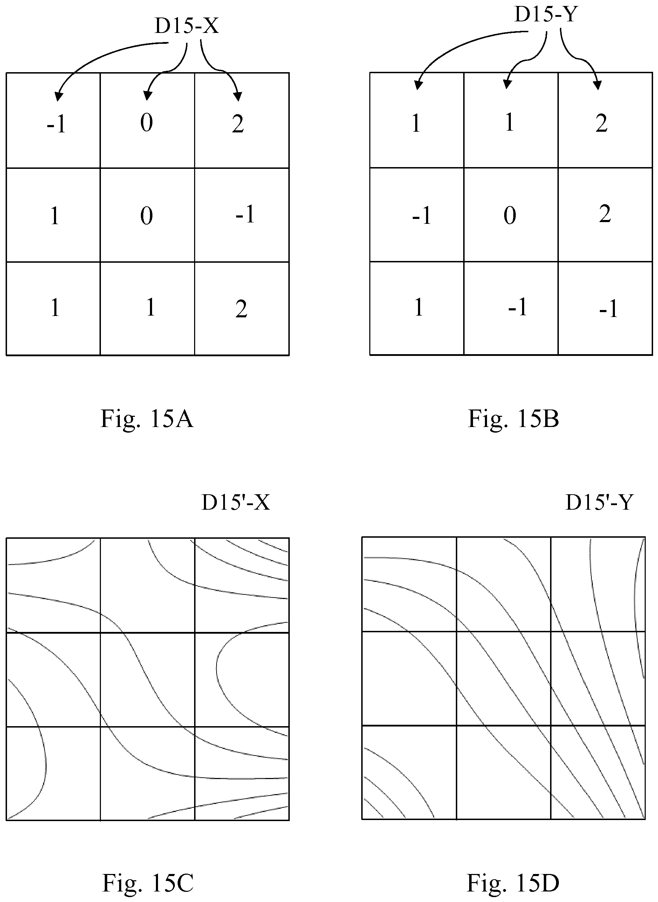

Fig. 15 shows an example of the interpolation of the X/Y-displacement vectors D15 between nine neighboring segments. Fig. 15 shows the originally assigned 2D-displacement vectors. In Figs. 15A and 15B these displacement vectors are divided into their respective X- and Y-components for each segment, denoted by D15-X and D15-Y. Fig.15C shows a contour-line plot of interpolated values D15'-X with respect to the X-components of these vectors, and Fig.15D shows a contour-line plot of interpolated values D15'-Y with respect to the Y-components of these vectors. Hence, in total this interpolation yields a continuous function of displacement vectors defined by the components D15'-X and D15'-Y.

### Multi-Beam System Datapath with Short-Range Distortion Correction

Figs. 14A and 14B illustrate how the above distortion corrections are incorporated in the datapath flow, in two respective variant processes.

The complete pattern image comprises a vast amount of image data, which is why for efficient processing of this data a high-speed datapath is needed that generates the pixel data to be exposed, preferably in real-time. The pattern to be exposed is typically described in a vector format, e.g. as a collection of geometries like rectangles, trapezoids or general polygons, which typically offers better data compaction and therefore reduces the requirements on data storage. The datapath comprises three major parts:
1) a distortion correction processing unit, which may implement one of above variants a), b) or c)
2) a rasterization process to translate the vector to pixel data, and
3) a buffer to temporarily store the pixel data for the writing process.

The distortion correction according to the invention can be done either prior to rasterization (Fig. 14A), or after rasterization (Fig. 14B).

Fig. 14A shows a flowchart 120 of the datapath for the case when the distortion correction is done prior to rasterization. The datapath starts upon being supplied a pattern to be exposed 121, presented e.g. as a vector data file.

Stage 122: The exposure area is segmented into smaller areas. In a preferred realization of the invention these areas are small (or of about the same size) in comparison to the area of the beam array field of the multi-bream writer. Corrections that can be applied in the vector domain (e.g. proximity effect correction) may be carried out to all chunks independently, possibly in parallel, and the resulting data is sorted and coded in a way to improve computation speed of the following steps. The output is a collection of chunks where all chunks contain a collection of geometries.

Stage 123: The pattern to be exposed is prepared for distortion corrected according to one of the above variants a), b) or c). Each of the variants comprises a step where particular features or point coordinates of the pattern to be exposed are assigned to a respective segment of the exposure area. In particular, variants b) and c) comprise a step where the pattern to be exposed is divided into smaller features.

Stage 124: Next, the distortion correction is performed separately for each segment. In accordance with the invention, these corrections may include parameters such as scaling SX01, SY01 in both spatial directions X and Y, a rotation R01, an angle correction A01 and most importantly a X/Y-positioning-correction D01, as shown in Fig. 8C.

Stage 125 is Rasterization for the Multi-Beam Tool: The geometries of every feature are converted to a raster graphics array, where the pixel gray level represents the physical dose of the corresponding aperture image. Every pixel that is completely inside a geometry is assigned the gray level (intensity value) of the polygon, whereas the gray level of pixels that cross an edge of a geometry is weighed by the fraction of the area of the pixel that is covered by the geometry. This method implies a linear relation between the area of the geometry and the total dose after the rasterization. The doses are first calculated as floating point numbers; only later they are converted to the discrete set of dose values as supported by the PD device. As a result of rasterization the pixel data will be in the format of floating point numbers representing nominal dose values for the respective pixels.

Stage 126 comprises other pixel-based corrections, such as dose corrections and/or defective beam corrections. Details for these corrections can be found elsewhere and are not part of the invention. This step may be skipped if no pixel-based corrections are required.

Stage 127 provides Dithering: The dithering process converts the dose value data into gray value data, based on a predetermined gray value scale. This is a position-dependent rounding process that ensures that rounding errors are averaged over nearby pixels which, combined with oversampling, allows for a much finer dose variation than with the discrete set of dose values available for a single aperture (see section "Illustration of the Compensation Method"). This conversion can be realized by means of known algorithms for the conversion of visual image data into pixel graphics. It is possible to apply additional corrections (which are not part of the present invention) at this stage, provided they can be applied in the pixel domain, immediately before or after dithering depending on the actual correction (e.g. defective apertures correction).

Stage 128 is Pixel Packaging: The pixel image obtained from stage 127 is sorted according to the placement grid sequence and sent to the pixel buffer 129 of the electronic pattern information processing system 18 (Fig. 1). The pixel data is buffered until a sufficient amount of data, typically at least the length of a stripe to be imaged on the target, is present which triggers the exposure of the stripe. The data is taken out of the buffer during the writing process. After the stripe has been written, the process described above starts anew for the pattern data of the next region, such as the next stripe.

As mentioned above and illustrated in the data path flowchart 130 of Fig. 14B, for variant b) and c) there is also the possibility to implement the stages of the distortion correction 133, 134, 135 after rasterization 132, as shown in Fig. 14B. In other respect, the same considerations apply as discussed above with Fig. 14A; in particular, the stages 131 and 136-139 are equivalent to the stages 121 and 125-129 of data path 120. To account for the discretized nature of a raster graphics, the dislocation corrections may additionally require a rounding of the dislocated locations to the raster coordinates.

## Claims

1. Method for computing an exposure pattern for exposing a desired pattern on a target (16) in a charged-particle lithography apparatus, in which a particle beam (lb, 50) is directed to and illuminates a pattern definition device (4) comprising an aperture array (26) composed of a plurality of blanking apertures (24) through which said particle beam (pb) penetrates for writing said desired pattern by exposing a multitude of pixels within an exposure area on the target,
said method taking into account a spatially dependent distortion of the target within the exposure area, with respect to dislocations transversal to the direction of the particle beam,
wherein the method comprises:
(i) subdividing the exposure area into a plurality of non-overlapping sub-regions (91),
(ii) determining, for each of said subregions (91), a subregion dislocation (93), said subregion dislocation (93,93') comprising a set of parameters (D01, R01, A01, SX01, SY01) describing the distortion of the target at the location of the respective subregion (91', 91"),
(iii) providing the desired pattern as a graphical representation (PG0, PN0, PL0) on the exposure area on the target, said graphical representation being composed of a plurality of graphical elements, each graphical element located at a respective position in the exposure area,
(iv) modifying the graphical representation in accordance with the plurality of subregion dislocations (93, 93'), by dislocating each graphical element according to a subregion dislocation of the subregion which includes the respective position of the graphical element, obtaining a plurality of graphical elements thus dislocated, which compose a corrected graphical representation (PG0', PG0S, PN0', PL0'),
(v) calculating, from the corrected graphical representation, an exposure pattern defined on the multitude of pixels, said exposure pattern being suitable to create a nominal dose distribution on the target realizing contour lines representing the desired pattern.

2. The method according to claim 1, wherein each dislocation (93) comprises a displacement vector describing a linear translation of a representative point of the respective subregion (91) within a plane transversal to the direction of the particle beam.

3. The method according to claim 1 or 2, wherein each dislocation (93) comprises a plurality of parameters describing a dislocation of a representative point of the respective subregion (91) within a plane transversal to the direction of the particle beam, said parameters including at least one of an angle of rotation (R01), angle of shear (A01), scaling along an X-direction (SX01) and scaling along a Y-direction (SY01).

4. The method of any of the preceding claims, wherein the aperture array (26) of the pattern definition device (4) is imaged on the target, generating a beam array field on the target, which is composed of a plurality of aperture images, and wherein at least some of the subregions are smaller than the area covered by a beam array field.

5. The method of any of the preceding claims, wherein the graphical representation comprises graphical elements defined as polygons each comprising vertices, and in step iv) dislocation of each graphical element is performed by dislocating each vertex according to a subregion dislocation of the subregion which includes the respective position of the vertex.

6. The method of any of the preceding claims, wherein the graphical representation comprises graphical elements defined as polygons each comprising vertices, and in step iv) dislocation of each graphical element is performed by dislocating portions of polygons, where each portion is assigned to a respective subregion, according to a subregion dislocation of the respective subregion.

7. The method of claim 6, wherein a polygon crossing a boundary between subregions is divided into portions of polygons along the subregion boundaries.

8. The method of claim 6 and 7, wherein for each polygon comprising more than one portion, the portions of the polygon are re-joined into one polygon after being dislocated,

9. The method of any of claims 6 to 8, wherein critical polygon features are treated as completely belonging to one subregion.

10. The method of claim 6, wherein a polygon is divided into arbitrary portions, each portion falling within the area of a subregion with its complete area and/or with its center of mass and/or with the center of a bounding box minimally surrounding the portion and/or with any other reference point of choice, which subregion determines the subregion dislocation of the respective portion.

11. The method of any of the preceding claims, wherein parameters of the displacements of the subregions are interpolated by means of a multivariate interpolation, and the interpolated displacement parameters (D15'-X, D15'-Y) are applied to relevant positions of the graphical elements, such as a center of mass or the vertices of a graphical element.

12. The method of any one claims 1 to 11, wherein after modifying the graphical representation in step iv) the graphical representation is rasterized to obtain a raster graphics, which is used for calculating the exposure pattern in step v).

13. The method of any one claims 1 to 11, wherein the graphical representation used in step iv) is a raster graphics, preferably obtained from a vector graphics by rasterization prior to step iv).

14. The method of any of the preceding claims, wherein in step i) the exposure area is subdivided into a plurality of non-overlapping sub-regions (91) according to a regular grid, preferably a rectangular or square grid.

15. Charged-particle multi-beam processing apparatus (1) for exposure of a target (16) by means of a structured beam of electrically charged particles, comprising:
- an illumination system (3),
- a pattern definition device (4) and
- a projection optics system (5),
the illumination system (3) being configured to produce a beam of said electrically charged particles and form it into a wide beam (lb) illuminating the pattern definition device (4), the pattern definition device (4) being configured to form the shape of the illuminating beam into a structured beam composed of a multitude of sub-beams in accordance with an exposure pattern, and the projection optics system (5) being configured to project an image of the beam shape defined in the pattern definition device onto the target (16), thus exposing a multitude of pixels (px) within an image area on the target,
said processing apparatus comprising a pattern information processing system (18) configured for calculating a corrected graphical representation and a corresponding exposure pattern using the method of any of the preceding claims.

## Patentansprüche

1. Verfahren zum Berechnen eines Belichtungsmusters für die Belichtung eines gewünschten Musters auf einem Target (16) in einem Lithographiegerät mit geladenen Teilchen, in dem ein Teilchenstrahl (lb, 50) auf eine Musterdefinitionsvorrichtung (4) gerichtet wird und diese beleuchtet, welche Musterdefinitionsvorrichtung ein Aperturenarray (26) aufweist, das aus einer Vielzahl von Blanking-Aperturen (24) besteht, durch die der Teilchenstrahl (pb) zum Schreiben des gewünschten Musters durch Belichten einer Vielheit von Pixels in einer Belichtungsfläche auf dem Target hindurchtritt,
welches Verfahren eine räumlich abhängige Verzerrung des Target in der Belichtungsfläche betreffend Versetzungen quer zur Richtung des Teilchenstrahls berücksichtigt,
wobei das Verfahren umfasst:
(i) Unterteilen der Belichtungsfläche in eine Vielzahl überlappungsfreier Teilbereiche (91),
(ii) Bestimmen einer Teilbereichsversetzung (93) für jeden dieser Teilbereiche (91), welche Teilbereichsversetzung (93, 93') einen Satz von Parametern (D01, R01, A01, SX01, SY01) umfasst, der die Verzerrung des Target jeweils an dem Ort des Teilbereichs (91', 91") beschreibt,
(iii) Bereitstellen des gewünschten Musters als graphische Darstellung (PG0, PN0, PL0) auf der Belichtungsfläche auf dem Target, welche graphische Darstellung aus einer Vielzahl graphischer Elemente besteht, wobei jedes graphische Element an einer zugehörenden Position in der Belichtungsfläche gelegen ist,
(iv) Modifizieren der graphischen Darstellung gemäß der Vielzahl von Teilbereichsversetzungen (93) dadurch, dass jedes graphische Element gemäß einer Teilbereichsversetzung des Teilbereichs, in dem die jeweilige Position des graphischen Elements liegt, verlagert wird, wodurch eine Vielzahl so verlagerter graphischer Elemente gewonnen wird, die zusammen eine korrigierte graphische Darstellung (PG0', PG0S, PN0', PL0') bilden,
(v) Berechnen eines auf der Vielheit der Pixels definierten Belichtungsmusters aus der korrigierten graphischen Darstellung, welches Belichtungsmuster dazu geeignet ist, eine Dosis-Sollverteilung auf dem Target zu erzeugen, die Konturlinien, die das gewünschte Muster wiedergeben, verwirklicht.

2. Verfahren nach Anspruch 1, wobei jede Versetzung (93) einen Versetzungsvektor umfasst, der eine lineare Verschiebung eines repräsentativen Punktes des jeweiligen Teilbereichs (91) in einer Ebene quer zur Richtung des Teilchenstrahls beschreibt.

3. Verfahren nach Anspruch 1 oder 2, wobei jede Versetzung (93) eine Vielzahl von Parametern umfasst, die eine Versetzung eines repräsentativen Punktes des jeweiligen Teilbereichs (91) in einer Ebene quer zur Richtung des Teilchenstrahls beschreiben, welche Parameter zumindest eine(n) aus einem Drehwinkel (R01), einem Scherwinkel (A01), einer Skalierung entlang einer X-Richtung (SX01) und einer Skalierung entlang einer Y-Richtung (SY01) beinhalten.

4. Verfahren nach einem der vorhergehenden Ansprüche, wobei das Aperturenarray (26) der Musterdefinitionsvorrichtung (4) auf das Target abgebildet wird und dabei auf dem Target ein Strahlen-Array-Feld erzeugt, das aus einer Vielzahl von Aperturenbilder zusammengesetzt ist, und wobei zumindest einige der Teilbereiche kleiner sind als das Gebiet, das von einem Strahlen-Array-Feld überdeckt wird.

5. Verfahren nach einem der vorhergehenden Ansprüche, wobei die graphische Darstellung graphische Elemente umfasst, die als Polygone definiert sind, die jeweils Eckpunkte aufweisen, und in Schritt iv) das Verlagern jedes graphischen Elements dadurch erfolgt, dass jeder Eckpunkt gemäß einer Teilbereichsversetzung jenes Teilbereichs verlagert wird, in dem jeweils die Position des Eckpunkts liegt.

6. Verfahren nach einem der vorhergehenden Ansprüche, wobei die graphische Darstellung graphische Elemente umfasst, die als Polygone definiert sind, die jeweils Eckpunkte aufweisen, und in Schritt iv) das Verlagern jedes graphischen Elements dadurch erfolgt, dass Teile von Polygonen, wobei jeder Teil einem jeweiligen Teilbereich zugeordnet ist, gemäß einer Teilbereichsversetzung des jeweiligen Teilbereichs verlagert wird.

7. Verfahren nach Anspruch 6, wobei ein Polygon, das über eine Grenze zwischen Teilbereichen hinweg reicht, entlang den Grenzen der Teilbereiche in Teile von Polygonen aufgeteilt wird.

8. Verfahren nach Anspruch 6 und 7, wobei für jedes Polygon, das mehr als einen Teil umfasst, die Teile des Polygons, nachdem sie verlagert worden sind, wieder zu einem Polygon zusammengefügt werden.

9. Verfahren nach einem der Ansprüche 6 bis 8, wobei kritische Merkmale von Polygonen als vollständig zu einem Teilbereich gehörend behandelt werden.

10. Verfahren nach Anspruch 6, wobei ein Polygon in beliebige Teile aufgeteilt wird, wobei jeder Teil mit seinem gesamten Gebiet und/oder mit seinem Schwerpunkt und/oder mit dem Mittelpunkt eines Begrenzungskastens, der den Teil minimal umgibt, und/oder mit einem anderen Bezugspunkt nach Wahl in das Gebiet eines Teilbereichs fällt, welcher Teilbereich die Teilbereichsversetzung des betreffenden Teils bestimmt.

11. Verfahren nach einem der vorhergehenden Ansprüche, wobei Parameter der Versetzungen der Teilbereiche mittels einer multivariaten Interpolation interpoliert werden und die interpolierten Versetzungsparameter (D15'-X, D15'-Y) auf zugehörende Positionen der graphischen Elemente, wie eines Schwerpunkts oder der Eckpunkte eines graphischen Elementes, angewendet werden.

12. Verfahren nach einem der Ansprüche 1 bis 11, wobei nach dem Modifizieren der graphischen Darstellung in Schritt iv) die graphische Darstellung gerastert wird, was eine Rastergraphik ergibt, die zum Berechnen des Belichtungsmusters in Schritt v) verwendet wird.

13. Verfahren nach einem der Ansprüche 1 bis 11, wobei die in Schritt iv) verwendete graphische Darstellung eine Rastergraphik ist, die vorzugsweise vor Schritt iv) aus einer Vektorgraphik abgeleitet wurde.

14. Verfahren nach einem der vorhergehenden Ansprüche, wobei in Schritt i) die Belichtungsfläche in eine Vielzahl überlappungsfreier Teilbereiche (91) gemäß einem regelmäßigen Gitter, vorzugsweise einem rechteckigen oder quadratischen Gitter, aufgeteilt wird.

15. Geladene-Teilchen-Multistrahl-Bearbeitungsgerät (1) zum Belichten eines Target (16) mittels eines strukturierten Strahls elektrisch geladener Teilchen, mit
- einem Beleuchtungssystem (3),
- einer Musterdefinitionsvorrichtung (4) und
- einer Projektionsoptik (5),
wobei das Beleuchtungssystem (3) dazu eingerichtet ist, einen Strahl der elektrisch genannten Teilchen zu erzeugen und in einen breiten Strahl (lb) zu formen, der die Musterdefinitionsvorrichtung (4) beleuchtet, die Musterdefinitionsvorrichtung (4) dazu eingerichtet ist, die Form des beleuchtenden Strahls in einen strukturierten Strahl, der aus einer Vielheit von Teilstrahlen gemäß einem Belichtungsmuster zusammengesetzt ist, zu formen, und die Projektionsoptik (5) dazu eingerichtet ist, ein Bild der in der Musterdefinitionsvorrichtung definierten Strahlform auf das Target (16) zu projizieren, wodurch eine Vielheit von Pixels (px) in einem Bildbereich auf dem Target belichtet wird,
welches Bearbeitungsgerät ein Musterinformationsverarbeitungssystem (18) umfasst, das zum Berechnen einer korrigierten graphischen Darstellung und eines entsprechenden Belichtungsmusters unter Verwendung des Verfahrens nach einem der vorhergehenden Ansprüche eingerichtet ist.

## Revendications

1. Procédé pour calculer un motif d'exposition pour exposer un motif souhaité sur une cible (16) dans un appareil de lithographie à particules chargées, dans lequel un faisceau de particules (lb, 50) est dirigé vers et éclaire un dispositif de définition de motif (4) comprenant un réseau d'ouvertures (26) composé d'une pluralité d'ouvertures d'extinction (24) à travers lesquelles ledit faisceau de particules (pb) pénètre pour écrire ledit motif souhaité par exposition d'une multitude de pixels à l'intérieur d'une zone d'exposition sur la cible,
ledit procédé tenant compte d'une distorsion dépendant de l'espace de la cible à l'intérieur de la zone d'exposition, par rapport à des dislocations transversales à la direction du faisceau de particules,
le procédé comprenant :
(i) subdiviser la zone d'exposition en une pluralité de sous-régions ne se chevauchant pas (91),
(ii) déterminer, pour chacune desdites sous-régions (91), une dislocation de sous-région (93), ladite dislocation de sous-région (93, 93') comprenant un ensemble de paramètres (D01, R01, A01, SX01, SY01) décrivant la distorsion de la cible à l'emplacement de la sous-région respective (91', 91''),
(iii) fournir le motif souhaité sous forme de représentation graphique (PG0, PN0, PL0) sur la zone d'exposition sur la cible, ladite représentation graphique étant composée d'une pluralité d'éléments graphiques, chaque élément graphique étant situé au niveau d'une position respective dans la zone d'exposition,
(iv) modifier la représentation graphique selon la pluralité de dislocations de sous-région (93, 93'), par dislocation de chaque élément graphique selon une dislocation de sous-région de la sous-région qui comprend la position respective de l'élément graphique, et obtenir une pluralité d'éléments graphiques ainsi disloqués, qui composent une représentation graphique corrigée (PG0', PG0S, PN0' PL0')
(v) calculer, à partir de la représentation graphique corrigée, un motif d'exposition défini sur la multitude de pixels, ledit motif d'exposition étant approprié pour créer une distribution de dose nominale sur la cible réalisant des lignes de contour représentant le motif souhaité.

2. Procédé selon la revendication 1, dans lequel chaque dislocation (93) comprend un vecteur de déplacement décrivant une translation linéaire d'un point représentatif de la sous-région respective (91) dans un plan transversal à la direction du faisceau de particules.

3. Procédé selon la revendication 1 ou 2, dans lequel chaque dislocation (93) comprend une pluralité de paramètres décrivant une dislocation d'un point représentatif de la sous-région respective (91) à l'intérieur d'un plan transversal à la direction du faisceau de particules, lesdits paramètres comprenant au moins l'un parmi un angle de rotation (R01), un angle de cisaillement (A01), une mise à l'échelle le long d'une direction X (SX01) et une mise à l'échelle le long d'une direction Y (SY01).

4. Procédé selon l'une quelconque des revendications précédentes, dans lequel le réseau d'ouvertures (26) du dispositif de définition de motif (4) est imagé sur la cible, générant un champ de réseau de faisceaux sur la cible, qui est composé d'une pluralité d'images d'ouverture, et dans lequel au moins certaines des sous-régions sont plus petites que la zone recouverte par un champ de réseau de faisceaux.

5. Procédé selon l'une quelconque des revendications précédentes, dans lequel la représentation graphique comprend des éléments graphiques définis sous forme de polygones comprenant chacun des sommets et, dans l'étape iv), une dislocation de chaque élément graphique est réalisée par dislocation de chaque sommet selon une dislocation de sous-région de la sous-région qui comprend la position respective du sommet.

6. Procédé selon l'une quelconque des revendications précédentes, dans lequel la représentation graphique comprend des éléments graphiques définis sous forme de polygones comprenant chacun des sommets et, dans l'étape iv), une dislocation de chaque élément graphique est réalisée par dislocation de parties de polygones, chaque partie étant affectée à une sous-région respective, selon une dislocation de sous-région de la sous-région respective.

7. Procédé selon la revendication 6, dans lequel un polygone croisant une limite entre des sous-régions est divisé en parties de polygones le long des limites de sous-région.

8. Procédé selon les revendications 6 et 7, dans lequel, pour chaque polygone comprenant plus d'une partie, les parties du polygone sont de nouveau unies en un polygone après dislocation.

9. Procédé selon l'une quelconque des revendications 6 à 8, dans lequel des caractéristiques de polygone critiques sont considérées comme appartenant entièrement à une sous-région.

10. Procédé selon la revendication 6, dans lequel un polygone est divisé en parties arbitraires, chaque partie se trouvant dans la zone d'une sous-région avec sa zone entière et/ou avec son centre de masse et/ou avec le centre d'un cadre d'objet entourant au minimum la partie et/ou avec tout autre point de choix de référence, laquelle sous-région détermine la dislocation de sous-région de la partie respective.

11. Procédé selon l'une quelconque des revendications précédentes, dans lequel des paramètres des déplacements des sous-régions sont interpolés au moyen d'une interpolation multivariables, et les paramètres de déplacement interpolés (D15'-X, D15'-Y) sont appliqués à des positions pertinentes des éléments graphiques, tels qu'un centre de masse ou les sommets d'un élément graphique.

12. Procédé selon l'une quelconque des revendications 1 à 11, dans lequel, après modification de la représentation graphique dans l'étape iv), la représentation graphique est tramée pour obtenir un graphique de trames, qui est utilisé pour calculer le motif d'exposition dans l'étape v).

13. Procédé selon l'une quelconque des revendications 1 à 11, dans lequel la représentation graphique utilisée dans l'étape iv) est un graphique de trames, de préférence obtenu à partir d'un graphique vectoriel par tramage avant l'étape iv).

14. Procédé selon l'une quelconque des revendications précédentes, dans lequel, dans l'étape i), la zone d'exposition est subdivisée en une pluralité de sous-régions ne se chevauchant pas (91) selon une grille régulière, de préférence une grille rectangulaire ou carrée.

15. Appareil de traitement à faisceaux multiples de particules chargées (1) pour l'exposition d'une cible (16) au moyen d'un faisceau structuré de particules chargées électriquement, comprenant :
- un système d'éclairage (3),
- un dispositif de définition de motif (4), et
- un système optique de projection (5),
le système d'éclairage (3) étant configuré pour produire un faisceau desdites particules chargées électriquement et le former en un faisceau large (lb) éclairant le dispositif de définition de motif (4), le dispositif de définition de motif (4) étant configuré pour former la forme du faisceau d'éclairage en un faisceau structuré composé d'une multitude de sous-faisceaux selon un motif d'exposition, et le système optique de projection (5) étant configuré pour projeter une image de la forme de faisceau définie dans le dispositif de définition de motif sur la cible (16), exposant ainsi une multitude de pixels (px) à l'intérieur d'une zone d'image sur la cible,
ledit appareil de traitement comprenant un système de traitement d'informations de motif (18) configuré pour calculer une représentation graphique corrigée et un motif d'exposition correspondant à l'aide du procédé selon l'une quelconque des revendications précédentes.
